(19) Europäisches Patentamt
European Patent Office
Office européen des brevets

(11) EP 0 707 015 B1

(12) **EUROPEAN PATENT SPECIFICATION**

(45) Date of publication and mention of the grant of the patent:
**15.12.1999 Bulletin 1999/50**

(51) Int Cl.$^6$: **C08F 8/00**, G03F 7/004, C08F 212/14

(21) Application number: **95810624.7**

(22) Date of filing: **04.10.1995**

(54) **Polymers**

Polymere

Polymères

(84) Designated Contracting States:
**BE CH DE FR GB IT LI NL**

(30) Priority: **13.10.1994 CH 307994**

(43) Date of publication of application:
**17.04.1996 Bulletin 1996/16**

(73) Proprietor: **ARCH SPECIALTY CHEMICALS, INC.**
**Norwalk, Connecticut 06856-4500 (US)**

(72) Inventors:
- **Mertesdorf, Carl-Lorenz, Dr.**
  **D-79189 Bad Krozingen (DE)**
- **Falcigno, Pasquale Alfred**
  **CH-4052 Basle (CH)**
- **Münzel, Norbert, Dr.**
  **D-79423 Heitersheim (DE)**
- **Schacht, Hans-Thomas, Dr.**
  **D-79618 Rheinfelden (DE)**

(74) Representative:
**Klunker . Schmitt-Nilson . Hirsch**
**Winzererstrasse 106**
**80797 München (DE)**

(56) References cited:
**EP-A- 0 342 498**
**EP-A- 0 520 642**
**EP-A- 0 552 548**
**EP-A- 0 588 544**
**US-A- 4 603 101**

Remarks:
The file contains technical information submitted after the application was filed and not included in this specification

EP 0 707 015 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The present invention relates to polymers containing hydroxyl groups and acid-labile ketal side groups, to radiation-sensitive compositions comprising these polymers, to a process for the production of images using these compositions, and to the use of the polymers as positive photoresists.

Positive-working radiation-sensitive mixtures are known. In particular, positive-working resist materials comprising o-quinone diazides in binders which are soluble in aqueous-alkaline media, for example novolaks, are employed commercially.

The production of highly integrated circuits currently requires the ability for structures having a width of less than 0.35 μm to be transferred imagewise to the substrate. The resolution capacity, for example of an o-quinone diazide/novolak system, has reached the limits of the physically possible at a wavelength of 365 nm, which is used for the imagewise exposure. For this reason, there is increasing interest in photoresists which work at shorter wavelengths in the deep UV (DUV, from 200 to 300 nm). Novolaks absorb so strongly in this region that uniform exposure over the usual layer thickness of approximately 1.0 μm is impossible. In order to ensure the requisite optical transparency, poly (p-hydroxystyrene) or a derivative thereof is generally used as binder resin in photoresists working in the DUV region.

As is generally known, systems of increased radiation sensitivity comprise, for example, alkali-soluble binder resins whose alkali-solubilizing groups, for example hydroxyl groups, have been blocked by acid-labile protecting groups, thus rendering the binder resins substantially insoluble in alkali. Exposure then initiates a primary reaction of an acid photogenerator which absorbs at the appropriate wavelength, forming a strong acid which, in the subsequent secondary reaction, results in removal of the protecting groups and thus in re-formation of the solubilizing groups.

An example which may be mentioned of such systems is poly(p-hydroxystyrene) whose phenol groups are protected by, for example, tert-butoxycarbonyloxy (t-Boc) or tetrahydropyranyl (THP) groups. Photoresists comprising such binder resins are known (see, for example, M.J. Bowden and S.R. Turner (Eds.) "Electronic and Photonic Application of Polymers", ACS Series 218, Washington, 1988, and N. Hayashi et al., Polymer 33, 1583 (1992)), but have disadvantages concerning adhesion to silicon.

It is known that copolymers comprising free phenolic monomer units exhibit increased thermal stability losses. Thermally induced decomposition (autocatalysis) can be attributed to partial de-protection owing to the catalytic effect of the weakly acidic phenolic hydroxyl groups.

The thermal flow resistance of the relief structures produced is highly dependent on the glass transition temperature ($T_g$) of the binder resin. With increasing content of protecting groups, $T_g$ and consequently the flow resistance of the resist structures decrease. However, an adequate flow resistance (dimensional stability of the resist structures produced) is of fundamental importance for the plasma-chemical structure transfer (etching process) onto the semiconductor substrate (TiN, $SiO_2$, and Al) which follows the lithographic process.

For conversion of alkali-insoluble into alkali-soluble, i.e. in order to achieve good lithographic contrast, it is important that the majority of the protecting groups, i.e. more than 90 %, is removed during the secondary reaction (O. Nalamasu et al., SPIE Vol. 1262, Advances in Resist Technology and Processing VII (1990) 32-48). For this reason, a maximum degree of protection of 50 % is set, so that the binder resin is just insoluble in the basic developers usually used and the number of protecting groups removed in the secondary reaction is sufficient to render the binder resin soluble.

Furthermore, photoresists with protecting groups are very sensitive to the process interval between the primary reaction and the subsequent secondary reaction. Extended intervals (post exposure delay), which become critical after only a few minutes in sensitive systems, result in considerable surface inhibition, with the consequence of the formation of T-shaped denatured profiles (S.A. MacDonald et al., SPIE Vol. 1466, Advances in Resist Technology and Processing VIII (1991) 2-7).

Furthermore, US Patent 5 258 257 discloses photoresists which comprise an acid photogenerator and a partially hydrogenated poly(hydroxystyrene) in which, in order to achieve good lithographic contrast and the requisite flow resistance, at most 50 % of the hydroxyl groups have been blocked by acid-labile protecting groups.

These photoresists have the disadvantage that the thermal stability is low owing to autocatalysis, in particular if the acid lability of the protecting groups used is very high. This considerably restricts the shelf life of such photoresists.

EP-A-520 642, and EP-A-588 544 disclose a photoresist composition comprising a polymer, a compound which generates an acid upon exposure to light and a solvent capable of dissolving the polymer and the compound. The polymer comprises hydroxystyrene repeating units, a portion of which have protecting groups, namely ketal or acetal groups. None of the explicitly disclosed polymers has a degree of protection of more than 50%. A higher degree of protection would result in the disadvantages mentioned above.

The object of the present invention is to develop polymers and positive-working, highly active radiation-sensitive systems resulting therefrom, in particular for the production of relief structures, which do not have the abovementioned disadvantages, i.e. they should in particular have good process stability, be sensitive to UV radiation, electron beams and X-rays and in particular should be suitable for use in the DUV region owing to their high optical transparency.

Surprisingly, it has been found that replacement of from 50 % to 90 % of the hydroxyl groups in partially hydrogenated poly(hydroxystyrene) by ketal groups gives highly active radiation-sensitive mixtures which do not have the above-described disadvantages, such as poor contrast and inadequate flow resistance, which typically occur in phenolic binder resins having a protecting-group content of greater than 50 %. The radiation-sensitive mixtures comprise these polymers, which are insoluble in aqueous-alkaline solutions, and a compound which forms an acid on exposure to radiation. The polymers contain certain groups which are removed under acid catalysis, increasing the solubility of the mixture in an aqueous-alkaline solution. These mixtures are furthermore distinguished, in particular, by high flow resistance of the structures produced and have a good shelf life and a high resolution capacity.

The present invention thus relates to polymers having a molecular weight ($M_w$) of from $5.5 \times 10^3$ to $10^5$, measured by gel permeation chromatography, which comprise, in the polymer chain, recurring structural units of the formulae I-IV

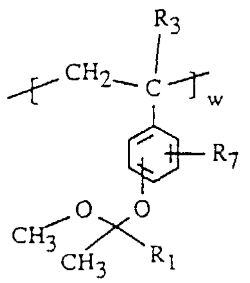 (I), 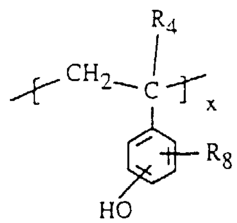 (II), 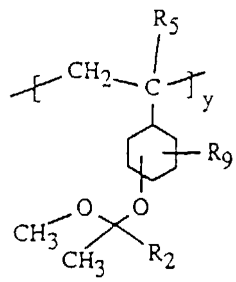 (III),

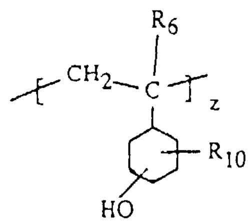 (IV),

in which $R_1$ and $R_2$, independently of one another, are each linear or branched $C_1$-$C_6$alkyl, unsubstituted or methyl-substituted $C_3$-$C_6$cycloalkyl, or phenyl or naphthyl which is unsubstituted or substituted by one or more halogen atoms or one or more $C_1$-$C_4$alkoxy, cyano or nitro groups,

$R_3$, $R_4$, $R_5$ and $R_6$, independently of one another, are hydrogen or methyl,

$R_7$, $R_8$, $R_9$ and $R_{10}$, independently of one another, are hydrogen, $C_1$-$C_6$alkyl, $C_1$-$C_6$alkoxy or halogen,

w, x, y and z are a number greater than or equal to 1,

and where the quotient Q, obtainable from the total number of structural units containing protecting groups divided by the total number of all structural units present,

$$Q = \frac{w + y}{w + x + y + z},$$

is greater than 0.5 and at most 0.9.

The polymers according to the invention preferably have a molecular weight ($M_w$) of from 6,000 to 50,000, in particular from 6,500 to 20,000.

Preference is given to polymers in which the quotient Q is greater than 0.5 and at most 0.8, in particular greater than 0.5 and at most 0.7.

Preference is furthermore given to polymers comprising, in the polymer chain, recurring structural units of the formulae V-VIII

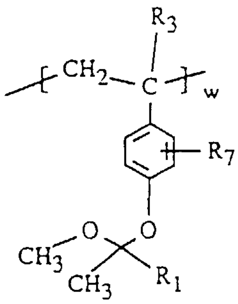 (V), 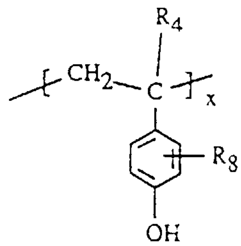 (VI), 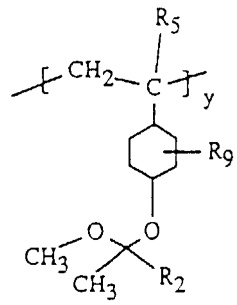 (VII),

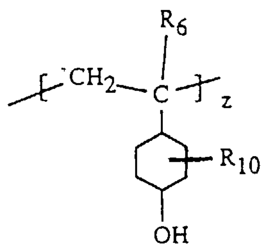 (VIII),

in which $R_1$-$R_{10}$, w, x, y and z are as defined above.

Preference is likewise given to polymers in which $R_1$ and $R_2$, independently of one another, are each linear or branched $C_1$-$C_6$alkyl or unsubstituted $C_3$-$C_6$cycloalkyl or phenyl, and $R_3$-$R_6$ and $R_7$-$R_{10}$ are hydrogen.

Very particular preference is given to polymers in which $R_1$ and $R_2$, independently of one another, are each methyl, cyclopropyl, cyclohexyl or phenyl.

Particular preference is given to polymers in which the quotient Q is greater than 0.5 and at most 0.7 and in which $R_1$ and $R_2$, independently of one another, are each linear or branched $C_1$-$C_6$alkyl or unsubstituted $C_3$-$C_6$cycloalkyl or phenyl.

Linear or branched $C_1$-$C_6$alkyl substituents are, for example, methyl, ethyl, n-propyl, isopropyl, n-butyl, sec-butyl, isobutyl, tert-butyl, n-pentyl, isopentyl, n-hexyl or isohexyl.

Unsubstituted or methyl-substituted $C_3$-$C_6$cycloalkyl substituents are, for example, cyclopropyl, 3- or 4-methylcyclopropyl, cyclobutyl, 3- or 4-methylcyclobutyl, cyclopentyl, 3- or 4-methylcyclopentyl, cyclohexyl or 3- or 4-methylcyclohexyl.

Examples of suitable $C_1$-$C_4$alkoxy substituents are methoxy, ethoxy, n-propoxy or n-butoxy.

Halogen substituents are fluorine, chlorine, bromine or iodine, preferably chorine or bromine, in particular chlorine.

The polymers are prepared in a known manner. For example, the monomers of the formulae

w 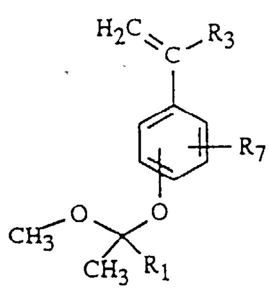 , x 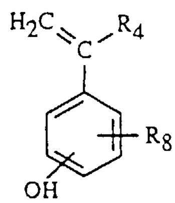 , y 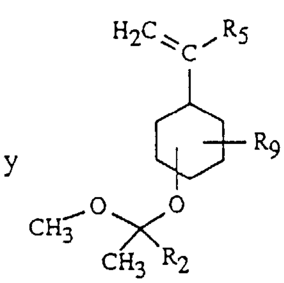 and z 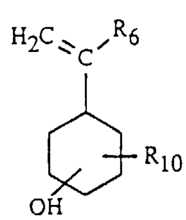 ,

in which $R_1$-$R_{10}$ are as defined above, are copolymerized with one another in a known manner in the amounts w, x, y and z respectively. The amount of each monomer used is calculated from the above-described parameters w, x, y and z.

A preferred preparation process comprises reacting a starting polymer comprising the structural units of the formulae Ia and Ib

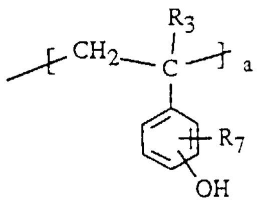 (Ia) and 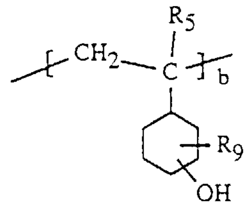 (Ib),

where the parameter a = w + x and the parameter b = y + z, with a compound of the formula

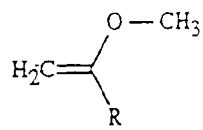

in an amount c = w + y, where the parameters w, x, y and z are as defined above, in a known manner (addition reaction). The substituent R represents $R_1$ and/or $R_2$.

The starting polymer comprising the structural units Ia and Ib is prepared, for example, by partial, metal-catalysed hydrogenation of poly(4-hydroxystyrene), as described in JP-A 01/103604.

As indicated at the outset, the novel polymers are used in positive photoresist formulations in electronics (electroplating resists, etch resists and solder resists), in chemical milling, in the production of printing plates, such as offset printing plates or screen printing plates, and printed circuits and in particular in microelectronics for the production of integrated circuits.

The invention thus also relates to radiation-sensitive compositions comprising, based on the total amount of components A) and B),

A) from 80 to 99.9 % by weight of a polymer according to the invention and
B) from 0.1 to 20 % by weight of a substance which forms an acid on exposure to actinic radiation.

Preference is given to radiation-sensitive compositions comprising, based on the total amount of components A) and B),

A) from 90 to 99.8 % by weight of a polymer according to the invention and
B) from 0.2 to 10 % by weight of a substance which forms an acid on exposure to actinic radiation.

The radiation-sensitive component B) which forms or eliminates an acid on exposure to light can be any of a large number of compounds. These include, for example, diazonium salts, as used in the diazotype process, o-quinone diazides, as used in known positive-working copying compositions, or halogen compounds which form hydrohalic acid on irradiation. Compounds of this type are described, for example, in US-A 3 515 552, 3 536 489 and 3 779 778, and in in DE-A 2 718 259, 2 243 621 and 2 610 842.

Suitable radiation-sensitive components B) of the compositions are in particular cationic photoinitiators from the group consisting of iodonium and sulfonium salts. Such compounds are described, for example, in "UV-Curing, Science and Technology" (Editor: S.P. Pappas, Technology Marketing Corp., 642 Westover Road, Stanford, Connecticut, USA).

It is also possible to use sulfoxonium salts as radiation-sensitive compounds. These salts are described, for example, in EP-B 35 969 and EP-A 44 274 and 54 509. Particular mention should be made of aliphatic sulfoxonium salts which absorb in the deep UV region.

It is also possible to employ sulfonic acid esters, as described, for example, in US 5 118 582, US 5 189 402 and by T. Ueno et al., Polym. Eng. Sci. 32, 1511 (1992).

Also suitable are other sulfonic acid esters, for example N-sulfonyloxyimides, as described, for example, in EP-A 502 677, and nitrobenzyl sulfonates, as described, for example, in US 5 135 838. Other sulfonyl compounds which can be used are described, for example, in DE-A 4 225 422 and Polym. Eng. Sci. 32, 1476 (1992).

Particular preference is given for irradiation with short-wave UV rays to disulfonic compounds, for example phenyl cumyl disulfone and phenyl 4-anisyl disulfone, which are described, for example, in DE 3 804 316.

Also suitable are, in particular, iminosulfonates, as described, for example, in EP-A 241 423 and EP-A 571 330.

It is also possible to employ compounds which liberate sulfonic acids on irradiation with actinic light. Such compounds are known per se and are described, for example, in GB-A 2 120 263, EP-A 84 515, 37 152 and 58 638, and US-A 4 258 121 and 4 371 605. Compounds which liberate carboxylic acids on irradiation are likewise suitable. Such compounds are described, for example, in EP-A 552 548.

If the radiation-sensitive, acid-liberating component B) is a salt, this is preferably soluble in organic solvents. The salt is particularly preferably a product with a complex acid, for example tetrafluoroboric acid, hexafluorophosphoric acid, trifluoromethanesulfonic acid, hexafluoroarsenic acid or hexafluoroantimonic acid.

The substances of component B) are expediently employed in an amount of 0.1-20 % by weight, preferably 0.1-15 % by weight, in particular 0.2-10 % by weight, based on the total amount of components A) and B).

Also preferred are compositions additionally comprising an inert organic solvent as component C) in addition to components A) and B).

The choice of organic solvent for component C) and its concentration depend principally on the nature of the composition of the resist formulation and on the coating process. The solvent should be inert, i.e. it should not undergo any chemical reaction with components A) and B), and it should be removable again on drying after coating. Examples of suitable solvents are ketones, ethers, esters and aromatic compounds, and any desired mixtures thereof. Examples thereof are methyl ethyl ketone, isobutyl methyl ketone, cyclopentanone, cyclohexanone, N-methylpyrrolidone, dioxane, tetrahydrofuran, 2-methoxyethanol, 2-ethoxyethanol; acetates, such as butyl acetate; 1-methoxy-2-propanol, 1,2-dimethoxyethane, diethylene glycol dimethyl ether, butyl glycol, alkylene glykol monoalkyl ethers, for example ethylcellosolve, ethylene glycol monobutyl ether and methylcellosolve, alkylene glycol alkyl ether esters, such as methylcellosolve acetate, ethylcellosolve acetate, propylene glycol ethyl ether acetate and methoxypropyl acetate, ethyl acetate, n-butyl acetate, ethyl 3-ethoxypropionate, methoxymethyl propionate, ethyl lactate, toluene and xylenes. Preferred organic solvents are ethyl lactate, ethoxyethyl propionate and in particular methoxypropyl acetate.

Preference is likewise given to compositions additionally comprising, based on the total amount of components A) and B), from 0.01 to 40 % by weight of conventional additives as component D).

The conventional additives are, for example, the following substances:

Pigments or dyes in amounts of from 0.1 to 2 % by weight, based on the total amount of components A) and B), for example Mikrolith Blau 4G, Orasolblau GN and Irgalithgrün.

Organic and inorganic fillers in amounts of from about 5 to 15 % by weight, based on the total amount of components A) and B), such as talc, quartz ($SiO_2$), barium sulfate ($BaSO_4$), aluminium oxide and calcium carbonates, by means of which, for example, the properties of a coating, such as its heat resistance, adhesion or scratch resistance, can be improved.

Weakly basic additives (paint additives) in a total amount of from 0.01 to 10% by weight, based on the total amount of components A) and B), such as antifoams (for example Byk 80), adhesion promoters (for example benzotriazole), fungicides and thixotropic agents or hydroxy-terminated polyglycol ethers containing ethylene oxide and/or propylene oxide units, for example Tetronic 701, 901, 908P and 1501 (BASF products).

Highly basic additives, such as aromatic and aliphatic amines, ammonium salts and N-containing heterocyclic compounds, usually in a concentration of from 0.01 to 1 % by weight, based on the total amount of components A), B) and C); examples of such basic additives are 2-methylimidazole, triisopropylamine, 4-dimethylaminopyridine and 4,4'-diaminodiphenyl ether.

Surfactants improve the wettability of the composition, prevent streaking on the resultant film, and improve the developability of the irradiated area. These surfactants include nonionic surfactants, for example polyoxyethylene lauryl ether, polyoxyethylene stearyl ether, polyoxyethylene oleyl ether, polyoxyethylene octylphenol ether, polyoxyethylene nonylphenol ether, polyethylene glycol dilaurate, polyethylene glycol distearate; fluorine-containing surfactants, for example F Top EF 301, EF 303 and EF 352 (Shin Akita Kasei K.K. products), Megafac F 171 and F 173 (Dainippon Ink & Chemicals products), Fluorad FC 430 and FC 431 (Sumitomo 3M Limited products), Asahi Guard AG 710, Surflon S-382, Surflon SC 101, SC 102, SC 103, SC 104, SC 105 and SC 106 (Asahi Glass Co., Ltd. products). Use is also made, for example, of the organosiloxane polymer KP 341 (Shin-Etsu Chemical Co., Ltd. product) and Polyflow No. 75 and No. 95 (Kyoeisha Yushikagaku Kogyo K.K. products), which are acrylic acid or methacrylic acid polymers. The amount of surfactant used is from 0.01 to 0.1 % by weight, based on the total amount of components A) and B).

Component D) is preferably an aliphatic or aromatic amine.

The resist formulations are prepared, for example, by mixing components A), B) and, if used, C) and D) with stirring at room temperature, giving a homogeneous solution.

The resist formulation is applied uniformly to the substrate at room temperature by known coating methods, for example by dipping, knife coating, brushing, spraying, in particular by electrostatic spraying and reverse-roll coating, and especially by spin coating.

The application rate (layer thickness) and the substrate type (layer support) depend on the desired area of application. The layer-thickness range generally covers values of from 0.1 to greater than 10 μm, preferably from 0.2 to 2.0 μm.

In microelectronics, the substrate is, for example, a surface-oxidized silicon wafer.

After the coating, the solvent is generally removed by drying, for example at temperatures from 70 to 130°C.

The resist film is a photoresist which, after drying, has high photosensitivity and very good adhesion to the substrate. Furthermore, it has high transparency and sensitivity, even in the deep UV region, in particular at 250 nm, and has a good thermal stability.

In order to produce relief structures, the substrate coated with the composition according to the invention is exposed imagewise. "Imagewise" exposure covers both exposure through a photomask containing a predetermined pattern, for example a transparency, and exposure with a laser beam, which is moved over the surface of the coated substrate, for example under computer control, and in this way generates an image, irradiation with computer-controlled electron beams, and exposure to X-rays or UV radiation through a corresponding mask.

In general, the exposure is carried out using UV and/or VIS radiation, preferably having a wavelength of from approx. 190 to 1,000 nm, in particular from 190 to 300 nm, and especially at 250 nm. The irradiation can be carried out using all known radiation sources, for example high-pressure mercury lamps or UV/VIS lasers and in particular excimer lasers (KrF excimer laser light having a wavelength of 248 nm). The radiation source can also be X-rays (for example synchrotron radiation) or beams of charged particles (for example electron beams), inter alia. The process parameters, for example the irradiation duration and the separation of radiation source and radiation-sensitive layer, generally depend on the nature of the radiation-sensitive composition and on the desired properties of the coating and can be determined by the person skilled in the art using a few routine experiments.

After imagewise exposure, the wafer is, if desired, heated at from 50 to 150°C for a few seconds to a few minutes (post exposure bake).

The exposed areas of the photoresist are then removed by dissolution in a developer. The choice of the particular developer depends on the type of photoresist, in particular on the nature of the binder used or of the photolysis products formed. The developer can include aqueous solutions of bases to which, if desired, wetting agents and organic solvents or mixtures thereof have been added.

The compositions are preferably used as positive photoresists. The invention therefore furthermore relates to a process for the production of positive images which comprises the following process measures:

I.) coating of a substrate with a radiation-sensitive composition comprising, based on the total amount of components A) and B),

A) from 80 to 99.9 % by weight of a polymer according to the invention and
B) from 0.1 to 20 % by weight of a substance which forms an acid on exposure to actinic radiation,

II.) exposure of the coated substrate to actinic radiation in a predetermined pattern, and
III.) development of the exposed substrate with a developer for positive-working photoresists.

Particularly preferred developers are aqueous-alkaline solutions, as also employed for the development of o-quinone diazide/novolak resist coatings. These include, for example, aqueous solutions of alkali metal silicates, phosphates, hydroxides and carbonates, but in particular tetraalkylammonium hydroxide solutions, for example tetramethylammonium hydroxide solution. If desired, minor amounts of wetting agents and/or organic solvents can also have been added to these solutions. Typical organic solvents which can be added to the developer liquids are, for example, cyclohexanone, 2-ethoxyethanol, acetone, isopropanol, ethanol, and mixtures of two or more of these solvents.

The developer is preferably applied by immersing the coated substrate which has been exposed imagewise into the developer solution, by spraying-on the developer solution or by repeated application of the developer to the coated substrate which has been exposed imagewise and removal of the developer by spinning.

The invention furthermore relates to the use of the compositions according to the invention as positive photoresists for the production of printing plates, printed circuits or integrated circuits.

The invention likewise relates to the printing plates, printed circuits and integrated circuits produced using the compositions according to the invention.

The examples below illustrate the invention.

Synthesis Example 1: Preparation of poly[4-(1-methoxy-1-methylethoxy)styrene / 4-(1-methoxy-1-methylethoxy) vinylcyclohexane/4-hydroxystyrene/ 4-vinylcyclohexanol] having a protecting group content of 63 % and a hydroxyl group content of 37 %

24.0 g of 2-methoxypropene are slowly added dropwise at 10°C to a solution of 20.0 g of partially hydrogenated poly-4-hydroxystyrene (Maruka Lyncur® PHM-C), a catalytic amount of toluene-4-sulfonic acid and a few drops of

pyridine in 140 ml of 1,4-dioxane. The reaction mixture is subsequently stirred at room temperature for 24 hours. The polymer is then precipitated by introducing the reaction solution into an isopropanol/water mixture. The polymer is filtered off, washed with an isopropanol/water mixture and subsequently dried to constant weight under reduced pressure, giving 24.0 g of a colourless powder which has the following properties:

- Thermogravimetric analysis TGA (10°C/min):

  Difference Δ (in the region below 250°C):
  Δ = 27.3 % by weight ⇒ Q = 0.63

  This corresponds to a polymer having a protecting group content of 63 % and a hydroxyl group content of 37 %.
- GPC (polystyrene calibration): $M_w$ = 8,280; PD (polydispersity) = 2.62.

<u>Synthesis Example 2</u>: Preparation of poly[4-(1-methoxy-1-methylethoxy)styrene / 4-(1-methoxy-1-methylethoxy) vinylcyclohexane/4-hydroxystyrene/ 4-vinylcyclohexanol] having a protecting group content of 69 % and a hydroxyl group content of 31 %

29.5 g of 2-methoxypropene are slowly added dropwise at 10°C to a solution of 20.0 g of partially hydrogenated poly-4-hydroxystyrene (Maruka Lyncur® PHM-C), a catalytic amount of toluene-4-sulfonic acid and a few drops of pyridine in 140 ml of 1,4-dioxane. The reaction mixture is subsequently stirred at room temperature for 24 hours. The polymer is then precipitated by introducing the reaction solution into an isopropanol/water mixture. The polymer is filtered off, washed with an isopropanol/water mixture and subsequently dried to constant weight under reduced pressure, giving 25.0 g of a colourless powder which has the following properties:

- TGA (10°C/min):

  Difference Δ (in the region below 250°C):
  Δ = 29.3 % by weight ⇒ Q = 0.69

  This corresponds to a polymer having a protecting group content of 69 % and a hydroxyl group content of 31 %.
- GPC (polystyrene calibration): $M_w$ = 7,020; PD (polydispersity) = 2.36.

<u>Synthesis Example 3:</u> Preparation of poly[4-(1-methoxy-1-methylethoxy)styrene / 4-(1-methoxy-1-methylethoxy) vinylcyclohexane / 4-hydroxystyrene / 4-vinylcyclohexanol] having a protecting group content of 73 % and a hydroxyl group content of 27 %

35.0 g of 2-methoxypropene are slowly added dropwise at 10°C to a solution of 20.0 g of partially hydrogenated poly-4-hydroxystyrene (Maruka Lyncur® PHM-C), a catalytic amount of toluene-4-sulfonic acid and a few drops of pyridine in 140 ml of 1,4-dioxane. The reaction mixture is subsequently stirred at room temperature for 24 hours. The polymer is then precipitated by introducing the reaction solution into an isopropanol/water mixture. The polymer is filtered off, washed with an isopropanol/water mixture and subsequently dried to constant weight under reduced pressure, giving 25.0 g of a colourless powder which has the following properties:

- TGA (10°C/min):

  Difference Δ (in the region below 250°C)
  Δ = 30.4 % by weight ⇒ Q = 0.73

This corresponds to a polymer having a protecting group content of 73 % and a hydroxyl group content of 27 %.

<u>Application Example 1:</u>

97.0 parts of the polymer prepared in Synthesis Example 1 (protecting group content 63 %) are dissolved, together with 3 parts of phenyl 4-anisyl disulfone, in 1-methoxy-2-propyl acetate having a total solids content of 25 % (photoresist solution 1). The solution is subsequently filtered through a filter having a pore diameter of 0.2 µm. This photoresist solution is spin-coated onto a silicon wafer in such a way that, after predrying for 60 seconds at 120°C on a hotplate, a film having a thickness of 0.83 µm is obtained. The exposure is carried out using a projection exposure unit (Canon FPA 4500, NA 0.37) with KrF excimer laser radiation (248 nm) in 5 mJ/cm steps. Drying of the wafer is

then completed on the hotplate at 120°C for 60 seconds, and the wafer is then developed for 60 seconds in commercially available 0.262 N tetramethylammonium hydroxide solution.

At an exposure dose of 65 mJ/cm, accurately reproduced, positive sub-semimicron structures having vertical profiles are obtained.

Application Example 2:

98.0 parts of the polymer prepared in Synthesis Example 1, having a protecting group content of 63 %, are dissolved, together with 2 parts of triphenylsulfonium triflate, in 1-methoxy-2-propyl acetate having a total solids content of 25 % (photoresist solution 2), and the solution is used analogously to Application Example 1.

Under analogous process conditions, a dose of 20 mJ/cm resolves sub-semimicron structures having vertical profile edges.

Application Example 3:

Photoresist solutions 1 and 2 were used analogously to Application Examples 1 and 2 under the same conditions with the difference that the process sequence between exposure and the subsequent drying step is interrupted for 1 hour (1 hour post-exposure delay).

The profiles of the developed structures are vertical, as described in Application Examples 1 and 2, and exhibit no T-shaped changes (no capping).

**Claims**

1. A polymer having a molecular weight ($M_w$) of from $5.5 \times 10^3$ to $10^5$, measured by gel permeation chromatography, which comprises, in the polymer chain, recurring structural units of the formulae I-IV

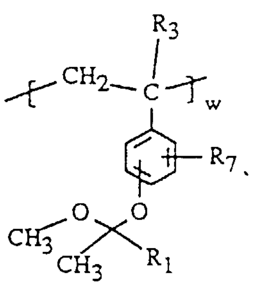 (I), 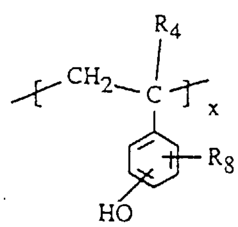 (II), 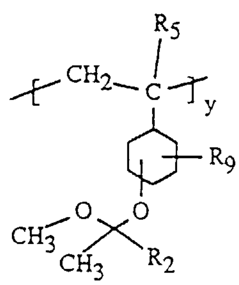 (III),

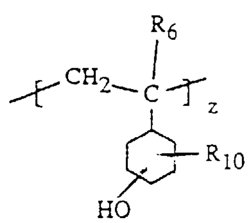 (IV),

in which $R_1$ and $R_2$, independently of one another, are each linear or branched $C_1$-$C_6$alkyl, unsubstituted or methyl-substituted $C_3$-$C_6$cycloalkyl, or phenyl or naphthyl which is unsubstituted or substituted by one or more halogen atoms or one or more $C_1$-$C_4$alkoxy, cyano or nitro groups,
$R_3$, $R_4$, $R_5$ and $R_6$, independently of one another, are hydrogen or methyl,
$R_7$, $R_8$, $R_9$ and $R_{10}$, independently of one another, are hydrogen, $C_1$-$C_6$alkyl, $C_1$-$C_6$alkoxy or halogen,
w, x, y and z are a number greater than or equal to 1,

and where the quotient Q, obtainable from the total number of structural units containing protecting groups divided by the total number of all structural units present,

$$Q = \frac{w + y}{w + x + y + z},$$

is greater than 0.5 and at most 0.9.

**2.** A polymer according to claim 1, in which the quotient Q is greater than 0.5 and at most 0.8.

**3.** A polymer according to claim 1, comprising, in the polymer chain, recurring structural units of the formulae V-VIII

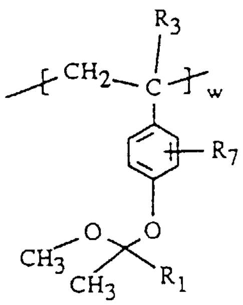 (V), 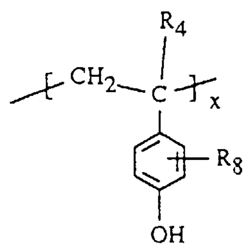 (VI), 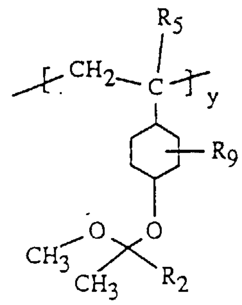 (VII),

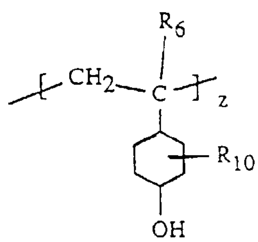 (VIII),

in which $R_1$-$R_{10}$, w, x, y and z are as defined in claim 1.

**4.** A polymer according to claim 1, in which $R_1$ and $R_2$, independently of one another, are each linear or branched $C_1$-$C_6$alkyl or unsubstituted $C_3$-$C_6$cycloalkyl or phenyl, and $R_3$-$R_6$ and $R_7$-$R_{10}$ are hydrogen.

**5.** A polymer according to claim 4, in which $R_1$ and $R_2$, independently of one another, are each methyl, cyclopropyl, cyclohexyl or phenyl.

**6.** A polymer according to claim 1, in which the quotient Q is greater than 0.5 and at most 0.7, and in which $R_1$ and $R_2$, independently of one another, are each linear or branched $C_1$-$C_6$alkyl or unsubstituted $C_3$-$C_6$cycloalkyl or phenyl.

**7.** A radiation-sensitive composition comprising, based on the total amount of components A) and B),

A) from 80 to 99.9 % by weight of a polymer according to claim 1 and
B) from 0.1 to 20 % by weight of a substance which forms an acid on exposure to actinic radiation.

**8.** A radiation-sensitive composition according to claim 7, comprising, based on the total amount of components A) and B),

A) from 90 to 99.8 % by weight of a polymer according to claim 1 and
B) from 0.2 to 10 % by weight of a substance which forms an acid on exposure to actinic radiation.

**9.** A radiation-sensitive composition according to claim 7, additionally comprising an inert organic solvent as component C) in addition to components A) and B).

**10.** A radiation-sensitive composition according to claim 7, additionally comprising, based on the total amount of components A) and B), from 0.01 to 40 % by weight of conventional additives as component D).

**11.** A process for the production of positive images by

I.) coating a substrate with a radiation-sensitive composition according to claim 7,
II.) exposing the coated substrate to actinic radiation in a predetermined pattern, and
III.) developing the exposed substrate with a developer for positive-working photoresists.

## Patentansprüche

**1.** Ein Polymer mit einem Molekulargewicht ($M_w$) im Bereich von 5,5 x $10^3$ bis $10^5$, gemessen mittels Gelfiltrationschromatographie, welches in der Polymerkette sich wiederholende Struktureinheiten der Formeln I-IV,

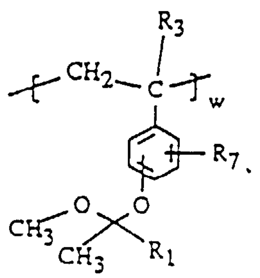 (I), 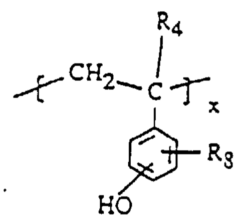 (II), 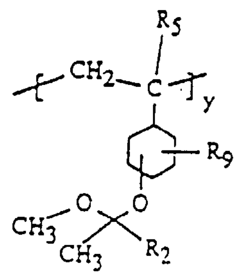 (III),

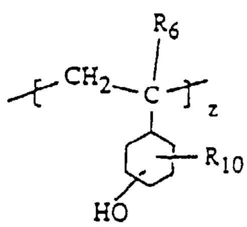 (IV),

enthält, in welchen $R_1$ und $R_2$ unabhängig voneinander jeweils lineares oder verzweigtes $C_1$-$C_6$Alkyl, unsubstituiertes oder methylsubstituiertes $C_3$-$C_6$Cycloalkyl oder Phenyl oder Naphthyl sind, welches unsubstituiert oder durch ein oder mehrere Halogenatome oder ein oder mehrere $C_1$-$C_4$Alkoxy-, Cyano- oder Nitrogruppen substituiert ist,
$R_3$, $R_4$, $R_5$ und $R_6$ unabhängig voneinander Wasserstoff oder Methyl sind,
$R_7$, $R_8$, $R_9$ und $R_{10}$ unabhängig voneinander Wasserstoff, $C_1$-$C_6$Alkyl, $C_1$-$C_6$Alkoxy oder Halogen sind,
w, x, y und z je eine Zahl sind, die größer als oder gleich 1 ist,

und wobei der Quotient Q, erhältlich aus der Gesamtzahl der über Schutzgruppen verfügenden Struktureinheiten geteilt durch die Gesamtzahl sämtlicher vorhandenen Struktureinheiten,

$$Q = \frac{w + y}{w + x + y + z},$$

größer als 0,5 und höchstens 0,9 ist.

**2.** Ein Polymer nach Anspruch 1, wobei der Quotient Q größer als 0,5 und höchstens 0,8 ist.

**3.** Ein Polymer nach Anspruch 1, welches in der Polymerkette sich wiederholende Struktureinheiten der Formeln V-VIII,

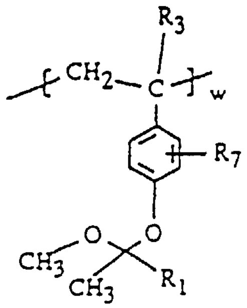 (V), 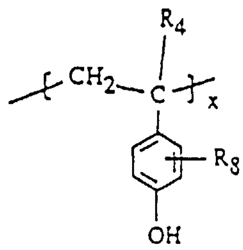 (VI), 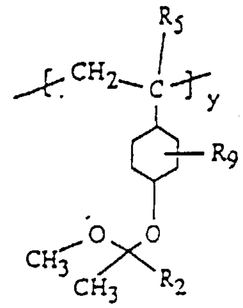 (VII),

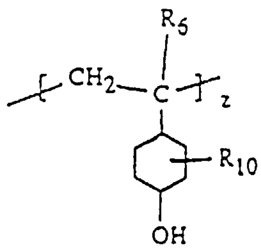 (VIII),

enthält, in welchen $R_1$-$R_{10}$, w, x, y und z der Definition in Anspruch 1 entsprechen.

**4.** Ein Polymer nach Anspruch 1, in dem $R_1$ und $R_2$ unabhängig voneinander je lineares oder verzweigtes $C_1$-$C_6$Alkyl oder unsubstituiertes $C_3$-$C_6$Cycloalkyl oder Phenyl, und $R_3$-$R_6$ sowie $R_7$-$R_{10}$ Wasserstoff sind.

**5.** Ein Polymer nach Anspruch 4, in welchem $R_1$ und $R_2$ unabhängig voneinander je Methyl, Cyclopropyl, Cyclohexyl oder Phenyl sind.

**6.** Ein Polymer nach Anspruch 1, in welchem der Quotient Q größer als 0,5 und höchstens 0,7 ist, und in welchem $R_1$ und $R_2$ unabhängig voneinander je lineares oder verzweigtes $C_1$-$C_6$Alkyl oder unsubstituiertes $C_3$-$C_6$Cycloalkyl oder Phenyl sind.

**7.** Eine strahlungsempfindliche Zusammensetzung, die, beruhend auf der Gesamtmenge der Komponenten A) und B),

A) aus 80 bis 99,9 Gewichtsprozent eines Polymers nach Anspruch 1 und
B) aus 0,1 bis 20 Gewichtsprozent einer Substanz, die, wenn sie einer aktinischen Bestrahlung ausgesetzt wird, eine Säure bildet,

besteht.

**8.** Eine strahlungsempfindliche Zusammensetzung nach Anspruch 7, die, beruhend auf der Gesamtmenge der Komponenten A) und B),

A) aus 90 bis 99,8 Gewichtsprozent eines Polymers nach Anspruch 1 und
B) aus 0,2 bis 10 Gewichtsprozent einer Substanz, die, wenn sie einer aktinischen Bestrahlung ausgesetzt wird, eine Säure bildet,

besteht.

**9.** Eine strahlungsempfindliche Zusammensetzung nach Anspruch 7, die zusätzlich zu den Komponenten A) und B) eine Komponente C), nämlich ein inertes organisches Lösungsmittel, enthält.

**10.** Eine strahlungsempfindliche Zusammensetzung nach Anspruch 7, die zusätzlich, beruhend auf der Gesamtmenge

der Komponenten A) und B), 0,01 bis 40 Gewichtsprozent an konventionellen Zusatzmitteln als Komponente D) enthält.

**11.** Ein Verfahren zur Erzeugung positiver Abbildungen durch

I.) Beschichtung eines Trägers mit einer strahlungsempfindlichen Zusammensetzung nach Anspruch 7,
II.) Exposition des beschichteten Trägers einer aktinischen Bestrahlung in einem vorgegebenen Muster und
III.) Entwickeln des exponierten Trägers mit einem Entwickler für positiv wirkende Photoresists.

**Revendications**

**1.** Un polymère ayant une masse moléculaire ($M_M$) dans la domaine de 5,5 x $10^3$ à $10^5$, mesuré au moyen de chromatographie par filtration sur gel qui comprend, dans la chaîne des polymères, les unités structurelles récurrentes des formules I-IV,

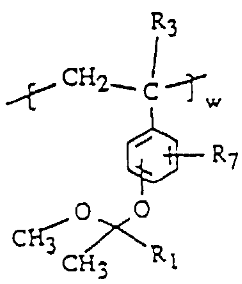 (I), 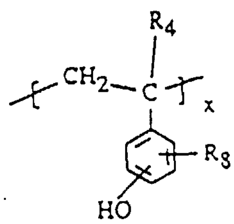 (II), 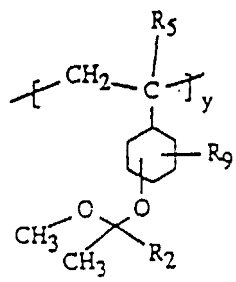 (III),

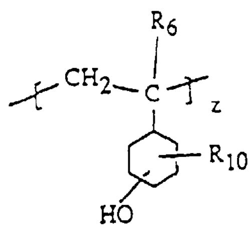 (IV),

dans lequel $R_1$ et $R_2$, indépendamment l'un de l'autre, sont un alkyle $C_1$-$C_6$ linéaire ou branché individuellement, un cycloalkyle, phényle ou naphtyle $C_3$-$C_6$ non substitué ou substitué par du méthyle, qui est non substitué ou substitué par un ou plusieurs atomes d'halogène, ou par un ou plusieurs groupes cyano ou nitro alkoxy $C_1$-$C_4$, $R_3$, $R_4$, $R_5$ et $R_6$, indépendamment les uns des autres, sont de l'hydrogène ou du méthyle,
$R_7$, $R_8$, $R_9$ et $R_{10}$, indépendamment les uns des autres, sont de l'hydrogène, de l'alkyle $C_1$-$C_6$, de l'alkoxy $C_1$-$C_6$ ou de l'halogène,
w, x, y et z sont un nombre supérieur ou égal à 1,

et où le quotient Q, qui peut être obtenu depuis le nombre total des unités structurelles contenant les groupes de protection divisé par le nombre total de toutes les unités structurelles présentes,

$$Q = \frac{w + y}{w + x + y + z}$$

est supérieur à 0,5, sans toutefois dépasser 0,9.

**2.** Un polymère conformément à la revendication 1, dans lequel le quotient Q est supérieur à 0,5, sans toutefois dépasser 0,8.

**3.** Un polymère conformément à la revendication 1, comprenant, dans la chaîne des polymères, les unités structurelles récurrentes des formules V-VIII

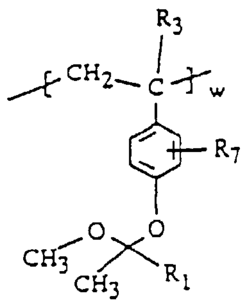 (V), 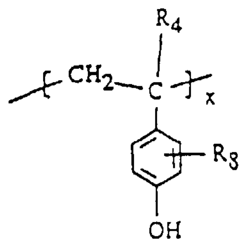 (VI), 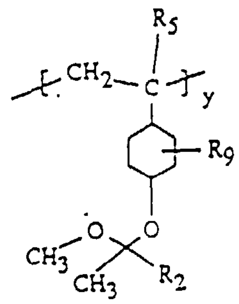 (VII),

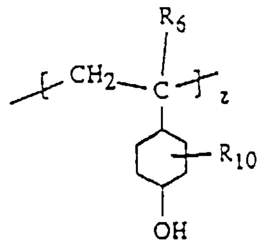 (VIII),

dans lequel $R_1$-$R_{10}$, w, x, y et z sont tels qu'ils sont définis dans la revendication 1.

**4.** Un polymère conformément à la revendication 1, dans lequel $R_1$ et $R_2$, indépendamment l'un de l'autre, sont un alkyle $C_1$-$C_6$ linéaire ou branché individuellement, un cycloalkyle ou phényle $C_3$-$C_6$ non substitué, tandis que $R_3$-$R_6$ et $R_7$-$R_{10}$ sont de l'hydrogène.

**5.** Un polymère conformément à la revendication 4, dans lequel $R_1$ et $R_2$, indépendamment l'un de l'autre, sont chacun du méthyle, du cyclopropyle, du cyclohexyle ou du phényle.

**6.** Un polymère conformément à la revendication 1, dans lequel le quotient Q est supérieur à 0,5, sans toutefois dépasser 0,7, et dans lequel $R_1$ et $R_2$, indépendamment l'un de l'autre, sont un alkyle $C_1$-$C_6$ linéaire ou branché individuellement, un cycloalkyle ou phényle $C_3$-$C_6$ non substitué.

**7.** Une composition sensible aux rayonnements comprenant, sur la base du montant total des composants A) et B),

A) de 80 à 99,9 % au poids d'un polymère conformément à la revendication 1, et
B) de 0,1 à 20 % au poids d'une substance qui forme un acide en cas d'exposition à des rayonnements actiniques.

**8.** Une composition sensible aux rayonnements conformément à la revendication 7 et comprenant, sur la base du montant total des composants A) et B),

A) de 90 à 99,8 % au poids d'un polymère conformément à la revendication 1, et
B) de 0,2 à 10 % au poids d'une substance qui forme un acide en cas d'exposition à des rayonnements actiniques.

**9.** Une composition sensible aux rayonnements conformément à la revendication 7 et comprenant également un solvant organique inerte comme composant C) en plus des composants A) et B).

**10.** Une composition sensible aux rayonnements conformément à la revendication 7 et comprenant également, sur la base du montant total des composants A) et B), de 0,01 à 40 % au poids d'adjuvants conventionnels comme composant D).

**11.** Un procédé permettant la production d'images positives en

I.) enduisant un substrat d'une composition sensible aux rayonnements conformément à la revendication 7,

II.) exposant le substrat enduit aux rayonnements actiniques selon un modèle déterminé à l'avance, et
III.) révélant le substrat exposé avec une solution de révélation pour agents photorésistants positifs.